(19) 

Europäisches Patentamt

European Patent Office

Office européen des brevets

(11) **EP 2 940 908 A1**

(12) **EUROPEAN PATENT APPLICATION**

(43) Date of publication:
**04.11.2015 Bulletin 2015/45**

(51) Int Cl.:
*H04B 17/00* $^{(2015.01)}$      *G06F 17/50* $^{(2006.01)}$

(21) Application number: **14305632.3**

(22) Date of filing: **28.04.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Chambre de Commerce et d'Industrie de Région Paris Ile de France (ESIEE Paris) 93160 Noisy Le Grand (FR)**

(72) Inventors:
• **Abi Mazen, Hussein**
  **78110 Le Vesinet (FR)**
• **Berland, Corinne**
  **75010 Paris (FR)**

(74) Representative: **Regimbeau**
  **20, rue de Chazelles**
  **75847 Paris Cedex 17 (FR)**

(54) **Method for simulating an electronic system based on a model comprising nonlinear blocks**

(57)    The invention relates to a method for simulating an electronic system based on a model of the electronic system comprising at least one nonlinear block, said block receiving an input signal x(t) and generating an output signal y(t) as a K-order polynomial of signal x(t), K being higher or equal to 2, said method comprising steps of :

a- (S1) decomposing the input signal x(t) into a number N of band-pass input signals, such that x(t) = $x_1$(t)+$x_2$(t) +...+$x_N$(t), each band-pass input signal $x_i$(t) being centered on a frequency $f_i$,

b- (S2) computing of a Fourier transform $X_i$(f) for each band-pass input signals $x_i$(t),

c- (S3) for k ranging from 2 to K, computing a set [$X_i^{(k)}$] of k-order signals, by convolving the signal $X_i$(f) with each k-1$^{th}$ order signal of the set [$X_j^{(k-1)}$], j ranging from i to N, starting from [$X_j^{(1)}$] = $X_j$(f)$^{(1)}$ = $X_i$(f),

d- (S4) computing the output signal Y(f) as a linear combination of signals of the sets [$X_i^{(k)}$], i ranging from 1 to N, k ranging from 1 to K, Y(f) being y(t) expressed in the frequency domain.

FIG. 3a

EP 2 940 908 A1

## Description

### FIELD OF THE INVENTION

The invention generally relates to computerized simulation of an electronic system, such as a radiofrequency transmitter or receiver, based on a model of such an electronic system, comprising one or more nonlinear blocks.

### BACKGROUND ART

The efforts of the electronic industry and amongst others the telecommunication industry are directed towards three main directions: 1) reducing size, power consumption and cost, 2) providing higher bit rate, 3) exploiting more efficiently the precious and limited spectrum resources in the case of a wireless technology.

Understanding the environment of electronic systems helps designers to achieving optimal performances. In particular, optimizing transmitters or receivers is an inherent process of compromises between linearity and noise requirements.

In an electronic system, it is generally hard to find the origin of certain signals generated by some blocks or components. In order to limit distortion or noise and find the best optimum, it is necessary to be able to precisely estimate the impact of each block on the signal of interest.

The case of bandpass signals is at the heart of the challenge.

Tracking mathematically all the nonlinear contributions of one block is a complex task. And with more than one block in cascade, the difficulty of the task exponentially increases.

Moreover, according to a given model, the nonlinearities have different orders, which add complexities.

Much of the modelling and simulation is run towards Excel calculation sheets to derive the specifications of the electronic system and to distribute them among its blocks using traditional system parameters (for the telecommunication: Gain, NF (Noise Figure), IP2 (second order interception point), IP3 (third order interception point), P1dB (1 dB compression point), Psat...

One- and two-tone tests are applied to accomplish this simulation phase. Nevertheless, the equations are only valid in case of continuous wave signals being processed.

System simulators, like ADS (developed by Agilent Technologies, now Keysight Technologies) and Spectre RF (developed by Cadence), are very efficient but they are time and memory consuming and most scenarios involving out-of-band blocking signals are extremely difficult to simulate.

Besides, some of system simulators are not able to compute separately the contributions of all types of interferences, such contributions being necessary to determine the performance of each block in the whole chain.

Other simulators operating in the frequency domain, as Genesys-Spectrasys from Agilent, are more adapted to dimension the electronic system. But they cannot handle bandpass modulated signals.

Being able to evaluate the impact of nonlinearities on a signal and identifying the origin of distortions, noises, and interferences, is a noticing breakthrough in the field of electronic systems and especially the telecommunication systems.

Mazen Abi Hussein and Corinne Berland have developed an advanced analytical method for simulating an electronic system.

As mentioned previously the most difficult task in such a development is to keep mathematical signal traceability when several signals are processed through cascaded blocks, especially through two or more nonlinear blocks. Nonlinearities of the blocks are modelled with polynomial function and traditional parameters such as gain, NF, IP2, IP3, P1dB, Psat are used to characterize the electronic system.

Among all nonlinear models, power series or polynomial models are the most widely used to simulate nonlinear systems, as they constitute a good compromise between complexity and accuracy. In case of "memoryless" systems, the output signal y(t) of a nonlinear block can be expressed as a function of the input signal x(t) as:

$$y(t)= \sum_{k=1}^{K} a_k x^k (t) \qquad\qquad [1]$$

$a_k$ coefficients being real constants that can be determined experimentally on the real electronic system and K being a polynomial order of the block.

The input signal x(t) can be decomposed into a sum of a number N of passband signals:

$$x(t) = x_1(t)+x_2(t)+\ldots+x_N(t) \tag{2}$$

each band-pass input signal $x_i(t)$ being centered on a predetermined frequency $f_i$.

Combining equations [1] and [2], and rewriting y(t), after a mathematical treatment, as

$$y(t)=\sum_{k=1}^{K} a_k y_k(t) \tag{3}$$

it can be shown that each term $y_k(t)$ produces $\binom{k+N-1}{k}2^{k-1}$ bandpass signals.

Therefore, the output signal y(t) can be decomposed into a new set of bandpass signals which can be used as input signals for a next nonlinear block.

Performing simulations in time domain using the above equation [3] can be computationally expensive since the number of bandpass signals generated increases exponentionnally with one block to the other, especially when high orders of nonlinearities are considered. Then, to lower the complexity, simulations are carried out in the frequency domain. The equivalent-frequency expression of the previous equation [3] is:

$$Y(f) = \sum_{k=1}^{K} a_k \sum_{\substack{k_1,\ldots,k_N \\ \sum k_i=k \\ 0\le k_i\le k}} \binom{k}{k_1,\ldots k_N} \coprod_{*}^{k_1} X_1(f) * \ldots * \coprod_{*}^{k_N} X_N(f)$$

$$= \sum_{k=1}^{K} a_k Y_k(f) \tag{4}$$

where $\coprod_{*}^{k} X(f) = X(f) * \ldots * X(f)$ is the k-convolution product of X(f).

According to equation [4], an important number of convolution products between the $X_i(f)$ has to be run. As a consequence, the simulation process may be resource- and time-consuming.

## SUMMARY OF THE INVENTION

One aim of the invention is to provide a method for simulating an electronic system which necessitates a lower number of calculations and operations so as to save time and resources.

To that aim, the invention provides a method for simulating an electronic system based on a model of the electronic system comprising at least one nonlinear block, said block receiving an input signal x(t) and generating an output signal y(t) as a K-order polynomial of signal x(t), K being higher or equal to 2, said method comprising steps of :

a- decomposing the input signal x(t) into a number N of band-pass input signals, such that $x(t) = x_1(t)+x_2(t)+\ldots+x_N(t)$, each band-pass input signal $x_i(t)$ being centered on a frequency $f_i$,
b- computing of a transform $X_i(f)$ into the frequency domain for each band-pass input signals $x_i(t)$,
c- for k ranging from 2 to K, computing a set $[X_i^{(k)}]$ of k-order signals, by convolving the signal $X_i(f)$ with each (k-1)-order signal of the set $[X_j^{(k-1)}]$, j ranging from i to N, starting from $[X_j^{(1)}]=X_j(f)$,
d- computing the output signal Y(f) as a linear combination of signals of the sets $[X_i^{(k)}]$, i ranging from 1 to N, k ranging from 1 to K, Y(f) being y(t) expressed in the frequency domain.

Step c allows minimizing the number of computing operations for determining the elementary signals of the sets $[X_i^{(k)}]$. Indeed, the operations carried out for computing each k order elementary signal use results of the operations carried out at the previous iteration for computing the k-1 order elementary signals.

Moreover, as the signal obtained at the output of each block is expressed as a sum of bandpass signals, the proposed method enables mathematically tracking noise and nonlinear interference contributions of each block of the model. In particular, it allows identifying input signals components generating noise and nonlinear interferences in the output signals.

According to one embodiment of the invention, each signal of the set $[X_i^{(k)}]$ is centered on one corresponding frequency of a set of frequencies $[f_i^{(k)}]$, i ranging from 1 to N, k ranging from 1 to K, and the transform Y(f) of the output signal y(t) into the frequency domain is a linear combination of a number M of bandpass signals of the sets $[X_i^{(k)}]$, the set of frequencies $[f_i^{(k)}]$ being equal to $[f_j^{(t-1)}] \pm f_i$, j ranging from i to N, i ranging from 1 to N, k ranging from 2 to K, starting from $[f_i^{(1)}] = f_i^{(1)} = f_i$,

According to one embodiment of the invention, the polynomial is defined as $y(t) = \sum_{k=1}^{K} a_k x^k(t)$, where coefficients $a_k$ are real constants that can be previously determined experimentally on the electronic system or that can be specified to determine parameters of the electronic system.

The coefficients $a_k$ may be computed as a function of specified parameters of the electronic system, such as gain, IP2, IP3, P1dB, Psat parameters.

The electronic system may be a telecommunication system, such as a radiofrequency receiver or transmitter.

The receiver or transmitter may be adapted to process modulated signals for radiocommunication systems.

According to one embodiment of the invention, the model comprises at least two nonlinear blocks, including a first block and a second block, and steps c and d are applied to the second block using a number P of output bandpass signals from the first block as input bandpass signals for the second block.

In particular, the method may comprise a step of selecting P signals having an amplitude higher than a predefined threshold amongst the M output signals of the first block or having a special interest, the P selected signals constituting the input signals for the second block.

The model may also comprise a linear block modeled with a frequency response H(f), said block receiving an input signal X(f) and generating an output signal Y(f) as a linear function of X(f)) and H(f).

## PRESENTATION OF THE DRAWINGS

The invention will be described with reference to the drawings, in which:

FIG.1 is a schematic representation of an electronic system comprising a single nonlinear block.

FIG.2 is a diagram illustrating different steps of a method according to a possible embodiment of the invention.

FIG.3a is a graphical representation of the signal sets, as implemented, with N=4 input bandpass signals and a third order nonlinearity (K=3).

FIG.3b is a schematic representation of the step c) of the method.

FIG. 4a is a representation of the frequencies of bandpass signals generated from a second order nonlinearity (K=2), with N=4 bandpass signals at the input.

FIG. 4b is a graphical representation of the frequency sets as implemented, with N=4 input bandpass signals and a third order nonlinearity (K=3).

FIG.5 is a schematic representation of an electronic system comprising two nonlinear blocks and one linear block.

FIG.6 is a schematic representation of a receiver comprising several blocks.

FIG. 7 is a diagram showing output signals from an intermodulation test.

## DEFINITIONS

A kth order of nonlinearities for a given signal means that the given signal is issued from a product of k bandpass input signals $x_i(t)$. Consequently, in the frequency domain, it means that the given signal is issued from a convolution product of k input signals $X_i(f)$.

For clarity reason, a "mixing" between two signals means hereby a convolution product.

## DETAILED DESCRIPTION OF AN EMBODIMENT OF THE INVENTION

The invention applies to electronic systems in general, in so far as the electronic systems comprise nonlinear blocks. More precisely, the invention finds a useful application when it is needed to identify sources of distortions, noises and interferences. Tracking of nonlinearities is a major stake.

The invention applies particularly to telecommunication system, such as radiofrequency receiver or transmitter. Besides, said receiver or transmitter is adapted to process modulated signals for radiocommunication systems such as 3G or 4G signals.

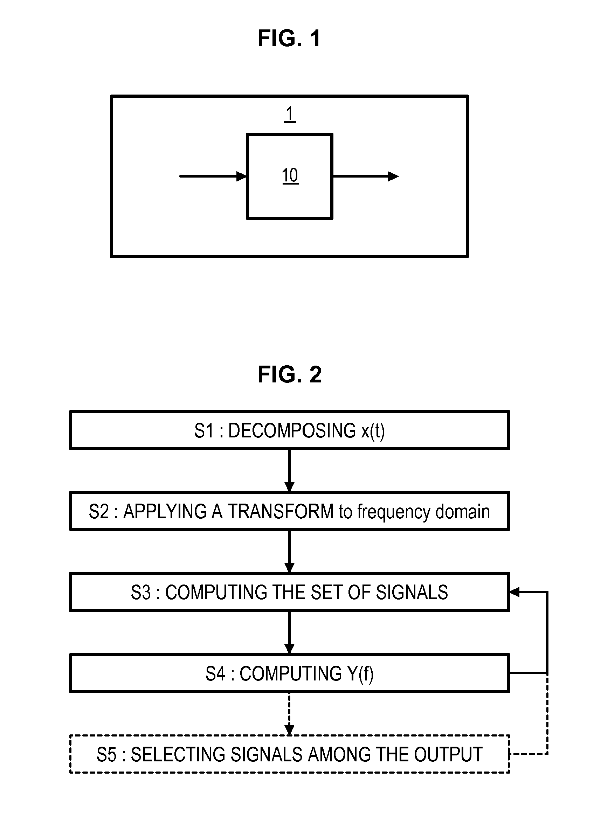

FIG.1 shows a representation of a model of an electronic system 1, comprising a nonlinear block 10. Said nonlinear block 10 receives an input signal x(t) and transmits an output signal y(t).

Said nonlinear block 10 is modelled as a K order polynomial function, which means that the output signal y(t) of said nonlinear block 10 can be expressed as $y(t) = \sum_{k=1}^{K} a_k x^k(t)$, where $a_k$ are real constant that can be determined experimentally or that can be specified to determine parameters of the model of the electronic system 1. For a nonlinear block, K is assumed to be higher or equal to 2.

Typically, said coefficients $a_k$ are computed as a function of said parameters such as gain, IP2, IP3, P1dB, Psat.

The input signal x(t) is modelled as a sum of a number N elementary bandpass signals as $x(t) = x_i(t) + ... + x_N(t)$. Without any loss of generality, each $x_i(t)$ is defined as a band limited signal centered around a predefined frequency $f_i$ being anywhere on the frequency spectrum, including zero. This is a broader definition that an usual bandpass signal which generally has to satisfy the condition of a bandwidth much smaller than the frequency $f_i$.

The model of the electronic system is stored in a digital memory and a simulation of the electronic system based on the model is carried out by a computer which is programmed for executing the steps illustrated on FIG. 2.

FIG. 2 is a diagram illustrating different steps of a method according to a possible embodiment of the invention.

According to a first step S1, the input signal is decomposed into said N elementary band pass signals $x_i(t)$, ..., $x_N(t)$.

According to a second step S2, conversion of the input signal x(t) into the frequency domain is applied. Any kind of transformation from time-to frequency-domain can be applied, as long as information on the phase of the signal is preserved. Preferably, a Fourier transform is applied. As for the rest of the description, it will be referred to a Fourier transform for clarity sake. The input signal x(t) is converted into X(f), and the N elementary bandpass signals $x_i(t)$ are converted into $X_i(f)$.

The output signal y(t) is given, under its Fourier transform expression Y(f), by:

$$Y(f) = \sum_{k=1}^{K} a_k \sum_{\substack{k_1,...,k_N \\ \sum k_i = k \\ 0 \le k_i \le k}}^{k} \binom{k}{k_1,...,k_N} \coprod_*^{k_1} X_1(f) * ... * \coprod_*^{k_N} X_N(f) = \sum_{k=1}^{K} a_k Y_k(f)$$

$$[4]$$

According to step S3, signal sets $[X_i^{(k)}]$ are computed as follows.

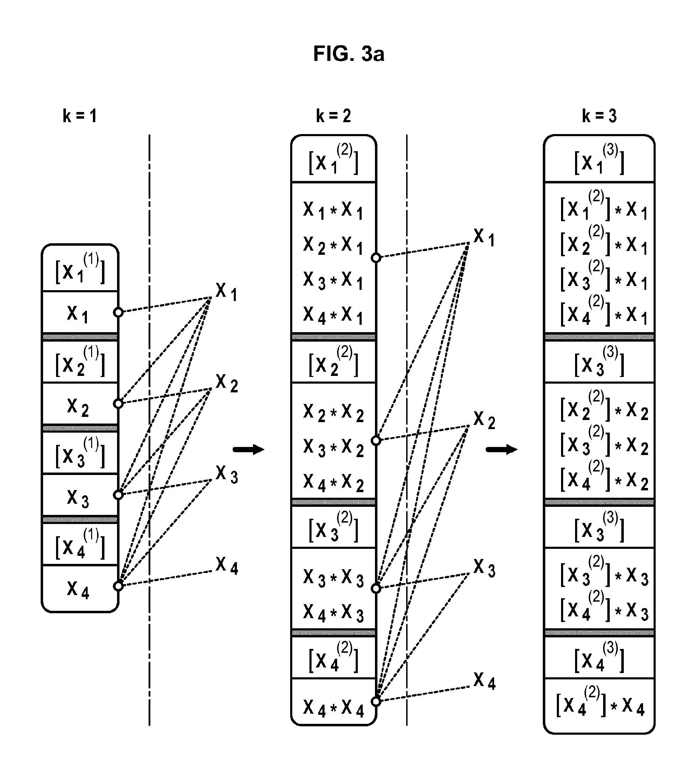

As illustrated on FIG. 3a, each signal set $[X_i^{(k)}]$ is computed as a set of $k^{th}$ order signals by mixing $X_i(f)$ with each signal of each set $[X_i^{(k-1)}]$, ..., $[X_N(f)^{(k-1)}]$, k ranging from 2 to K and the sets being initialized by $[X_1^{(1)}] = [X_1^{(1)}] = X_1(f)$, ..., $[X_N^{(1)}] = X_N(f)$.

FIG. 3a is a graphical representation of the signal sets computed for a number N=4 of input bandpass signals, and a third order nonlinearity (K=3).

For instance, it can be seen that the set $[X_2^{(2)}]$ is comprised of $X_2(f)*X_2(f)$, $X_3(f)*X_2(f)$ and $X_4(f)*X_2(f)$. This set $[X_2^{(2)}]$ does not include $X_2(f)*X_1(f)$ which has already been calculated and included in the set $[X_1^{(2)}]$ as $X_1(f)*X_2(f)$.

The fact that each set $[X_i^{(k)}]$ is computed from signals taken from previously computed sets $[xj^{(k-1)}]$, with $j \geqq i$. In other words, signals generated from lower nonlinearities orders are used to compute the signals generated from a higher order, thus avoiding redundancy in computing operations.

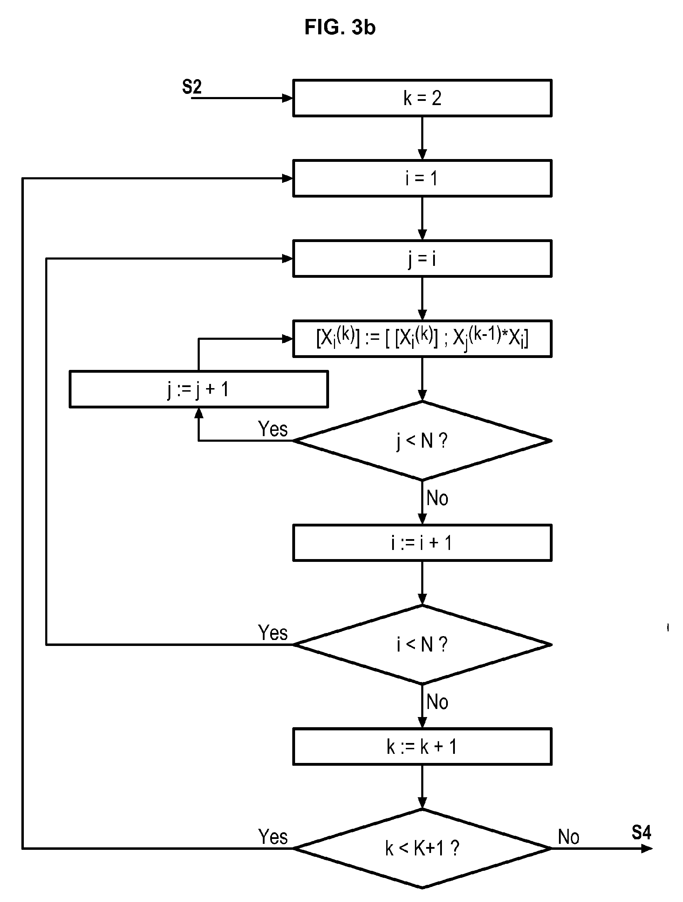

As illustrated on FIG. 3b, computation of the sets $[X_i^{(k)}]$ starts from k=2 and i=1 and comprises calculating all the $X_j(f)*X_1(f)$ for j=1,...,N, then all the $X_j(f)*X_2(f)$ for j=2,...,N until $X_j(f)*X_N(f)$ for j=N. All the signal sets $[X_i^{(2)}]$, i=1,... N, are thus calculated. Then, the next order sets is calculated by all the $[X_j^{(2)}] * X_i(f)$, for j=1,...N, and then $[X_j^{(2)}] X_2(f)$, for j=2,...N, until $[X_j^{(2)}] X_N(f)$, for j=N. At the $K^{th}$ order, the signal sets calculated are $[x_j^{(K-1)}] * X_1(f)$, for j=1,...N, until $[X_j^{(K-1)}] *X_N(f)$, for j=N. Thus, the computation of the $[X_i^{(k)}]$ ends at k=K and i=N.

In other words, at the $k^{th}$ order of nonlinearity, every input signal $X_i(f)$, i=1,...,N is mixed with all signals with a k-1$^{th}$ order of nonlinearity resulting from a previous mixing of $X_i(f)$,...$X_N(f)$.

We also denote the set of frequencies corresponding to $[X_i^{(k)}]$ by $[f_i^{(k)}]$.

When mixing two signals, for example say $X_1(f)$ and $X_2(f)$, centered on frequencies $f_1$ and $f_2$ respectively, the result is two bandpass signals centered on frequencies $|f_1 \pm f_2|$, even if $f_1$ and/or $f_2$ is equal to zero.

Thus, the sets of frequencies are known and set $[f_i^{(k)}]$ is equal to $[f_j^{(k-1)}] \pm f_i$, j ranging from i to N, i ranging from 1 to N, k ranging from 1 to K, starting from $[f_i^{(1)}]=f_i$.

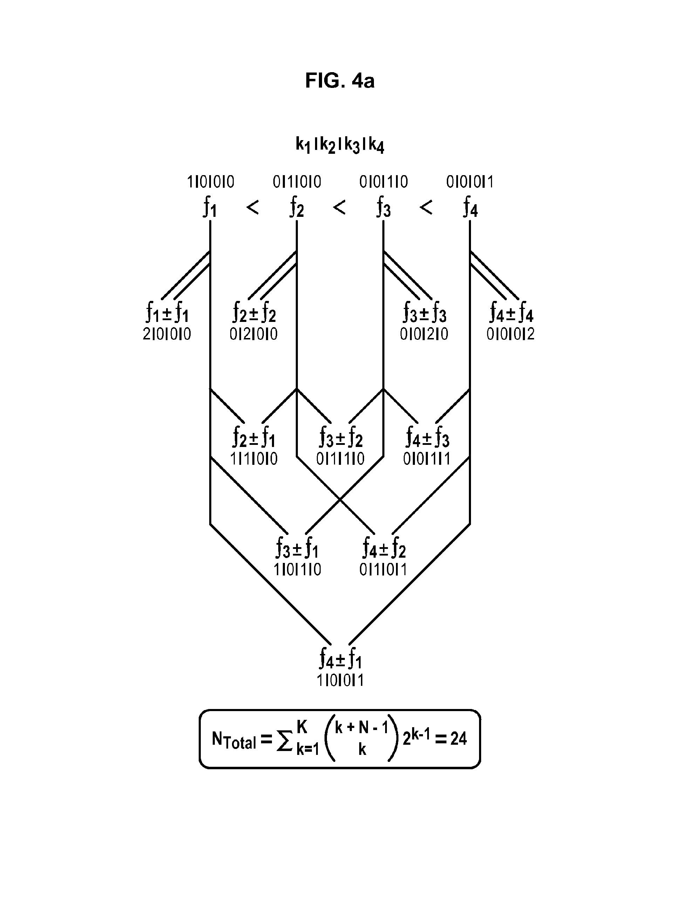

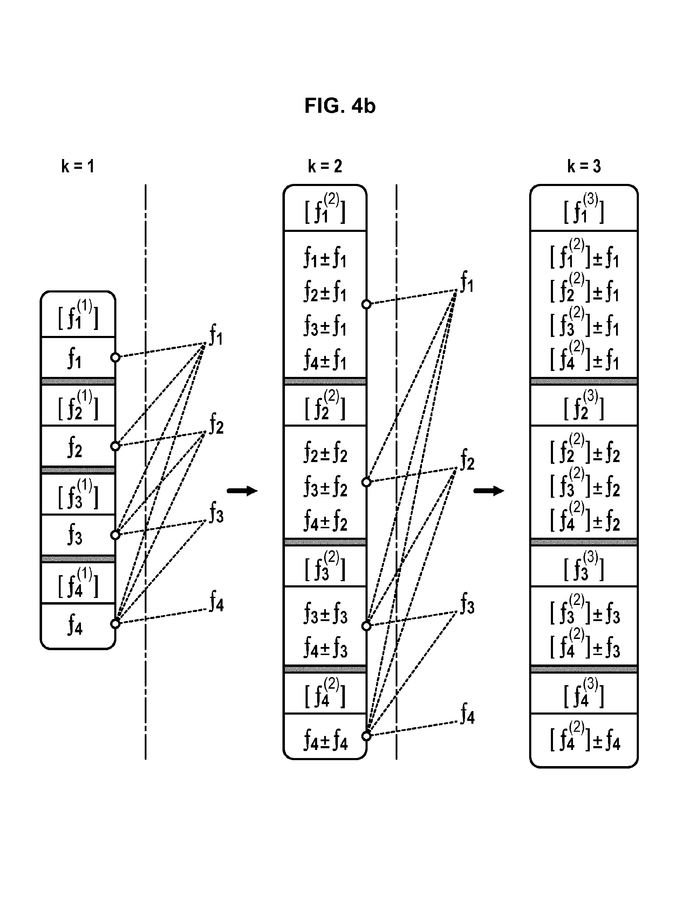

FIG. 4a illustrates the generation of the frequencies after mixing signals, in case of four bandpass input signals and a second order of nonlinearity. FIG. 4b shows the construction of said sets of frequencies related to their set of signals of FIG. 3a.

According to a fourth step S4, Y(f) is computed as a linear combination of signals from all the sets $[X_i^{(k)}]$, with

$1 \leq i \leq N$ and $1 \leq k \leq K$, from equation [4], by taking into account the multinomial coefficient $\begin{pmatrix} k \\ k_1,...,k_N \end{pmatrix}$ and the $a_k$ coefficients.

Thus Y(f) is not obtained through a transform into the frequency domain from y(t) but thanks to the evaluation of the sets $[X_i(f)^{(k)}]$. Therefore, step S4 does not incorporate a time to frequency transform calculation even if step S4 enables to obtain the output Y(f) in the frequency domain.

The output signal Y(f) is expressed as a sum of bandpass signals, say M bandpass signals, centered on a frequency which belongs to its respective set of frequencies.

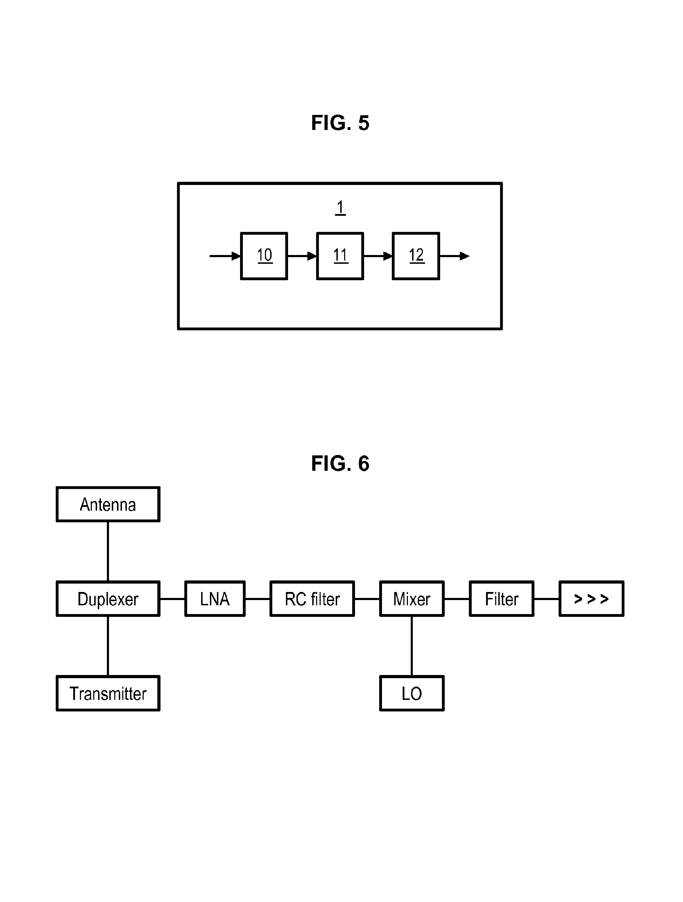

FIG. 5 is a schematic representation of an electronic system comprising two nonlinear blocks and one linear block. More precisely, the model of the electronic system 1 illustrated on FIG. 5 comprises a first nonlinear block 10, a second nonlinear block 11 and a third linear block 12.

The nonlinear block 10 is identical to the nonlinear block 10 of FIG. 1. The nonlinear block 11 is modelled in the same way, with its own coefficients $a_k$.

Blocks 10 and 11 are connected together so that the output signal Y(f) of block 10 is input into the next block 11. The M output bandpass signals from the first nonlinear block 10 becomes M input bandpass signals for the second nonlinear block 11

As the output signal Y(f) of the first block 10 is a sum of the M output bandpass signals, the third and fourth steps S3 and S4 of the method of the invention are directly applied to block 11.

Besides, according to a fifth step S5, the M output bandpass signals generated by the first block 10 are filtered so as to select only a reduced number of signals amongst the M output signals. This fifth step allows further limiting the number of computing operations.

Typically, signals are filtered according to a predefined threshold or a special criterion (for instance by selecting particular signals of interest).

According to a first possibility, step S5 consists in selecting all the signals having an intensity or a frequency above or below a predefined threshold.

According to a second possibility, the special criterion is determined by the nature of the signal of interest, which can have low levels of amplitude.

Blocks 11 and 12 are connected together so that the output signal Y(f) from block 11 is input into the next block 12. The P output bandpass signals from the second nonlinear block 11 becomes P input bandpass signals for the linear block 12. Said linear block 12 is modelled with its frequency response H(f).

By definition, the output signal Y(f) of the linear block 12 is a linear function of the input signal X(f) and H(f). Consequently, the P input bandpass signals are turned into P output bandpass signals by the linear block 12.

As a consequence, the linear block 12 does not interfere with the proposed method.

Typically, a linear block 12 models a filter, which can be represented by its frequency response, said filter being limited in a certain range of frequencies.

Example

FIG.6 is a schematic representation of a receiver modelled as several blocks. The antenna is considered as a source generating the useful received signal and all the interfering signals (in-band and out-of-band blockers) that may appear in real wireless applications. The duplexer and the RF (radiofrequency) filter may be modeled as selective frequency attenuators if the RF filtering specifications must be determined or by the transfer function of bandpass filters already designed. The LNA (Low Noise Amplifier) can be modeled as a nonlinear system. The mixer is composed of three cascaded blocks: an input nonlinearity followed by an ideal multiplier and output nonlinearity. The local oscillator can generate a sinusoidal signal and its harmonics and phase noise with a frequency profile based on an already designed circuit or a new circuit that should be designed. The filter at the end of the chain is considered as a low-pass filter assuming a direct conversion (homodyne) receiver. The transmitter is a nonlinear block used to model the leakage of the relatively high power transmitter in a full duplex transceiver.

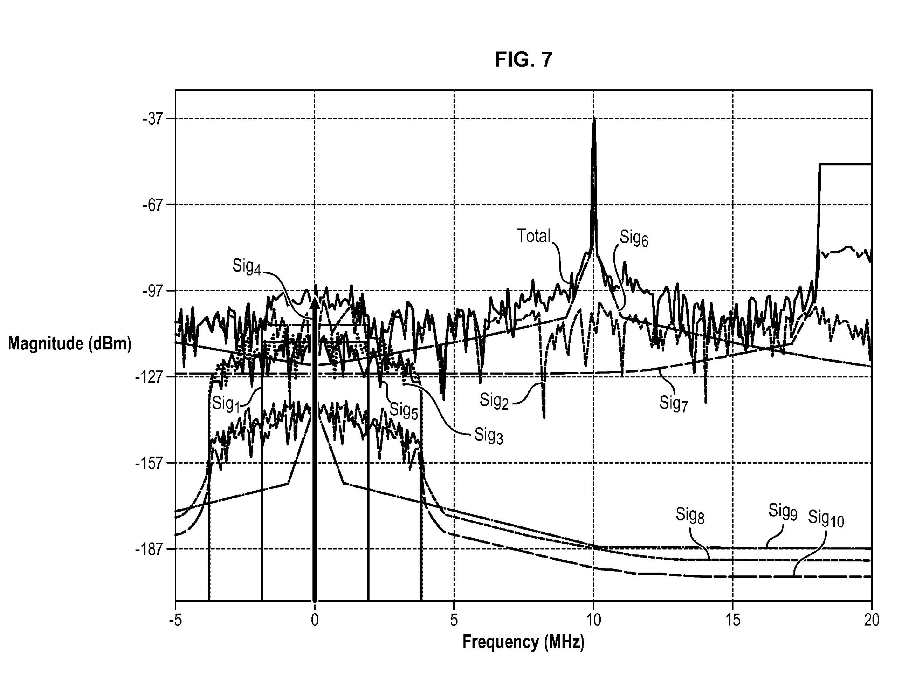

FIG.7 is a diagram showing output signals obtained by applying an intermodulation test to the receiver of FIG. 6. The intermodulation test measures the capacity of the receiver to reject intermodulation products resulting from two unwanted signals inside the interest band.

$Sig_1$ is the useful signal and 9 other signals with a significant interfering contribution can be observed. For example, the signal $Sig_2$ results from third order non-linearity of the LNA on two intermediate interfering signals; signals $Sig_6$ and $Sig_7$ spread over the useful signal Sig1 because of the LO phase noise; signals $Sig_8$, $Sig_9$, and $Sig_{10}$ represent the LO phase noise associated to signals $Sig_3$, $Sig_4$ and $Sig_5$ respectively. When interfering signals appear close to the useful signal $Sig_1$, the phase noise of the LO introduces significant amount of interference.

The invention thus enables to identify the sources of non-linearity interference.

**Claims**

1. A method for simulating an electronic system based on a model of the electronic system comprising at least one nonlinear block, said block receiving an input signal x(t) and generating an output signal y(t) as a K-order polynomial of signal x(t), K being higher or equal to 2, said method comprising steps of :

   a- (S1) decomposing the input signal x(t) into a number N of band-pass input signals, such that x(t) = $x_1(t)+x_2(t)+...+x_N(t)$, each band-pass input signal $x_i(t)$ being centered on a frequency $f_i$,

   b- (S2) computing of a transform $X_i(f)$ into the frequency domain for each band-pass input signal $x_i(t)$,

   c- (S3) for k ranging from 2 to K, computing a set $[X_i^{(k)}]$ of k-order signals, by convolving the signal $X_i(f)$ with each k-1$^{th}$ order signal of the set $[x_j^{(k-1)}]$,j ranging from i to N, starting from $[x_j^{(1)}]= X_j^{(1)}=X_j(f)$,

   d- (S4) computing the output signal Y(f) as a linear combination of signals of the sets $[X_i^{(k)}]$, i ranging from 1 to N, k ranging from 1 to K, Y(f) being y(t) expressed in the frequency domain.

2. The method according to claim 1, wherein each signal of the set $[X_i^{(k)}]$ is centered on one corresponding frequency of a set of frequencies $[f_i^{(k)}]$, i ranging from 1 to N, k ranging from 1 to K, and the Fourier transform Y(f) of the output signal y(t) is a linear combination of a number M of bandpass signals of the sets $[X_i^{(k)}]$, the set of frequencies $[f_i^{(k)}]$ being equal to $[f_j^{(t-1)}]\pm f_i$, j ranging from i to N, i ranging from 1 to N, k ranging from 2 to K, starting from $[f_i^{(1)}]= f_i^{(1)}= f_i$.

3. The method according to one of claims 1 and 2, wherein the polynomial is defined as $y(t)= \sum_{k=1}^{K} a_k x^k(t)$, where coefficients $a_k$ are real constants that can be previously determined experimentally on the electronic system or that can be specified to determine parameters of the electronic system.

4. The method according to claim 3, wherein said coefficients $a_k$ are computed as a function of specified parameters of the electronic system, such as gain, IP2, IP3, P1dB and Psat parameters.

5. The method according to claim 1, wherein the transform to the frequency domain is a Fourier transform.

6. The method according to any of the preceding claims, wherein said electronic system is a telecommunication system, such as a radiofrequency receiver or transmitter.

7. The method according to claim 6, wherein said receiver or transmitter is adapted to process modulated signals for radiocommunication systems.

8. The method according to one of claims 1 to 7, wherein the model comprises at least two nonlinear blocks, including a first block and a second block, and wherein steps c and d are applied to the second block using a number M of output bandpass signals from the first block as input bandpass signals for the second block.

9. The method according to claim 8, comprising a step of selecting signals having an amplitude higher than a predefined threshold amongst the M output signals of the first block or having a special interest, the selected signals constituting the input signals for the second block.

10. The method according to one of claims 8 and 9, wherein the model further comprises a linear block modeled with a frequency response H(f), said block receiving an input signal X(f) and generating an output signal Y(f) as a linear function of X(f) and H(f).

# FIG. 1

1

10

# FIG. 2

S1 : DECOMPOSING x(t)

S2 : APPLYING A TRANSFORM to frequency domain

S3 : COMPUTING THE SET OF SIGNALS

S4 : COMPUTING Y(f)

S5 : SELECTING SIGNALS AMONG THE OUTPUT

# FIG. 3a

**FIG. 3b**

S2 → [ k = 2 ]

[ i = 1 ]

[ j = i ]

$[X_i(k)] := [ \, [X_i(k)] \, ; \, X_j(k-1)*X_i]$

[ j := j + 1 ]

⬦ j < N ? — Yes (to j := j + 1)
No ↓

[ i := i + 1 ]

⬦ i < N ? — Yes
No ↓

[ k := k + 1 ]

⬦ k < K+1 ? — Yes / No → S4

# FIG. 4a

$$N_{Total} = \sum_{k=1}^{K} \binom{k+N-1}{k} 2^{k-1} = 24$$

# FIG. 4b

## FIG. 5

## FIG. 6

FIG. 7

Europäisches
Patentamt
European
Patent Office
Office européen
des brevets

## EUROPEAN SEARCH REPORT

Application Number

EP 14 30 5632

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Khaled M. Gharaibeh: "Nonlinear distortion in wireless systems - Chapters 3,4", Nonlinear distortion in wireless systems: Modeling and Simulation with MATLAB, 6 December 2011 (2011-12-06), XP055135725, DOI: 10.1002/9781119961734 ISBN: 978-1-11-996173-4 Retrieved from the Internet: URL:http://onlinelibrary.wiley.com/book/10.1002/9781119961734 [retrieved on 2014-08-21] | 1-8,10 | INV. H04B17/00 G06F17/50 |
| Y | * Preface; page xv * * paragraph [3.1.1] * * paragraph [3.1.11] * * paragraph [4.4.1] * * paragraph [4.4.5] * ----- | 9 | |
| Y | SCHNEIDER K W ET AL: "EFFICIENT SIMULATION OF MULTICARRIER DIGITAL COMMUNICATION SYSTEMS IN NONLINEAR CHANNEL ENVIRONMENTS", IEEE JOURNAL ON SELECTED AREAS IN COMMUNICATIONS, IEEE SERVICE CENTER, PISCATAWAY, US, vol. 11, no. 3, 1 April 1993 (1993-04-01), pages 328-339, XP000377956, ISSN: 0733-8716, DOI: 10.1109/49.219548 | 9 | **TECHNICAL FIELDS SEARCHED (IPC)** H04B G06F |
| A | * page 329, right-hand column, lines 1-11 * * page 329, right-hand column, lines 34-40 * * page 331, right-hand column, lines 12-20 * ----- | 1-8,10 | |

The present search report has been drawn up for all claims

| Place of search | Date of completion of the search | Examiner |
|---|---|---|
| The Hague | 21 August 2014 | Riposati, Benedetto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)